# EUROPEAN PATENT SPECIFICATION

(11) **EP 0 727 873 B1**
(45) Date of publication and mention of the grant of the patent: **16.01.2002**
(21) Application number: 96400299.2
(22) Date of filing: 14.02.1996
(51) Int. Cl.: H03H 9/58

(54) **Piezoelectric component having curved relay terminal**
Piezoelektrisches Bauelement mit gekrümmtem Anschlusselement
Composant piézoélectrique comportant une borne de connexion courbée

(30) Priority: 14.02.1995 JP 2567995
(43) Date of publication of application: 21.08.1996
(73) Proprietor: MURATA MANUFACTURING CO., LTD., Nagaokakyo-shi Kyoto-fu 226 (JP)
(72) Inventor: Shimura, Takashi, Nagaokakyo-shi, Kyoto-fu (JP)
(74) Representative: Joly, Jean-Jacques

(56) References cited:
- US-A- 4 656 385

## Description

### BACKGROUND OF THE INVENTION

### Field of the Invention

The present invention relates to a piezoelectric component used in an oscillation circuit, a filter circuit and the like.

### Description of the Related Art

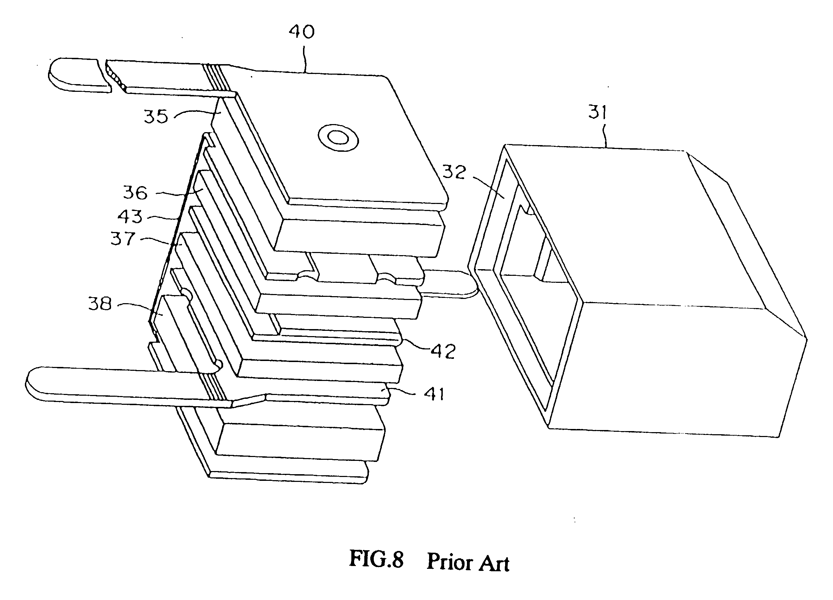

A conventional piezoelectric component shown in Fig.8 includes piezoresonators 35, 36, 37 and 38, an input terminal 40, an output terminal 41, a ground terminal 42 and a relay terminal 43 which are stacked and put into a case 31 through an opening 32. The relay terminal 43 is U-shaped, and serves to electrically connect the piezoresonators 35 and 38.

In the above conventional piezoelectric component, when the piezoresonators 35 to 38 and the terminals 40 to 43 are assembled in the case 31, the relay terminal 43 cannot be handled because of the U shape of the relay terminal 43. As a result, assembly of the piezoelectric component is difficult. This makes the mechanism of an automatic assembly machine complicated and hinders automation of the assembly operation.

US-A-4656385 discloses a piezoelectric component having the features of the pre-characterising portion of claim 1.

### SUMMARY OF THE INVENTION

The preferred embodiments of the present invention provide a piezoelectric component having a structure that allows the piezoresonators and terminals to be easily assembled in a case.

The preferred embodiments of the present invention also provide a piezoelectric component including a substantially box-shaped case, a piezoresonator to be inserted in the case through an opening of the case, and a pair of relay terminals each having a contact strip portion and a relay strip portion connected to the contact strip portion, the relay terminals being inserted in the case through the opening of the case to hold the piezoresonator, the relay strip portion of at least one of the pair of relay terminals being curved; characterised in that said relay strip portion of at least one of said first and second relay terminals is curved inwardly to have a substantially convex shape, so that the first and second relay terminals connect to form a single relay terminal element.

Furthermore, in the piezoelectric component of the preferred embodiments of the present invention, a guide for positioning the relay strip portions is preferably provided on the inner wall surface of the case, and each of the pair of relay terminals preferably has three relay strip portions.

According to the above structure, since the pair of relay terminals are separate before being inserted in the case, the relay terminals can be easily inserted in the case and stacked in the same manner as other terminals and piezoresonators, without variations in thicknesses of the piezoresonators and other terminals affecting the insertion and assembly process. Since the relay strip portion of at least one of the pair of relay terminals is curved, there is no possibility that the relay terminals will be deformed and thereby elastically fatigued. Therefore, there is also no possibility that the pressing force between the relay strip portions of the relay terminals will be reduced, and as a result, the relay strip portions are disposed in contact with each other by a sufficient pressing force. Accordingly, the relay terminals are electrically connected with reliability, and perform the same function as a conventional U-shaped relay terminal.

Furthermore, in the case where the relay strip portions of the pair of relay terminals are positioned by the guide portion formed on the inner wall surface of the case, the movement or slippage of the relay terminals is limited to a fixed amount by the guide portion which functions as a stopper even if a large external force is applied by the shock of the piezoelectric component falling, for example. Therefore, a large force is not allowed to be applied to the contact portions between the relay strip portions. As a result, good contact between the relay strip portions is achieved.

Still further, since the pair of relay terminals each preferably have three relay strip portions, the relay terminals are disposed in contact with each other at three positions. As a result, even when the relay terminals are tilted, displaced or shocked by falling or some other event, reduction in the amount or quality of contact between the relay terminals does not occur.

For the purpose of illustrating the invention, there is shown in the drawings several forms which are presently preferred, it being understood, however, that the invention is not limited to the precise arrangements and instrumentalities shown.

### BRIEF DESCRIPTION OF THE DRAWINGS

Fig.1 is an exploded perspective view showing a piezoelectric component according to a first preferred embodiment of the present invention;
Fig.2 is a fragmentary sectional view of the piezoelectric component shown in Fig.1;
Fig.3 is an internal plan view of the piezoelectric component shown in Fig. 1;
Fig.4 is a front view of a relay terminal used in the piezoelectric component shown in Fig.1;
Fig.5 is an electrical equivalent circuit diagram of the piezoelectric component shown in Fig.1;
Fig.6 is a front view of a pair of relay terminals used in a second preferred embodiment of the present invention;
Fig.7 is a front view of a pair of relay terminals used in a third preferred embodiment of the present invention; and
Fig.8 is an exploded perspective view of a conventional piezoelectric component.

### DESCRIPTION OF PREFERRED EMBODIMENTS

A piezoelectric component according to a first preferred embodiment of the present invention will now be described with reference to the attached drawings. Although a ladder-type filter is given as an example of the piezoelectric component in this preferred embodiment, the present invention is not limited to the ladder-type filter.

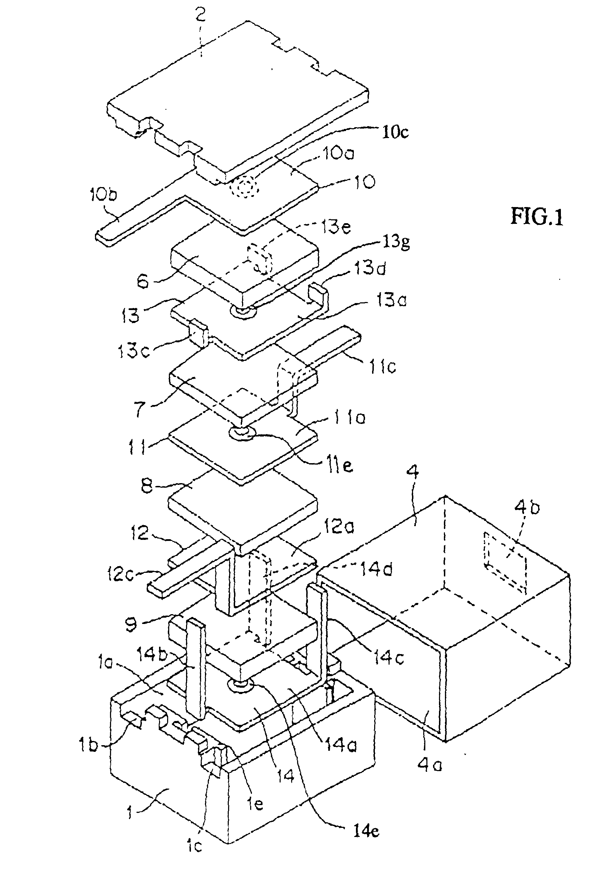

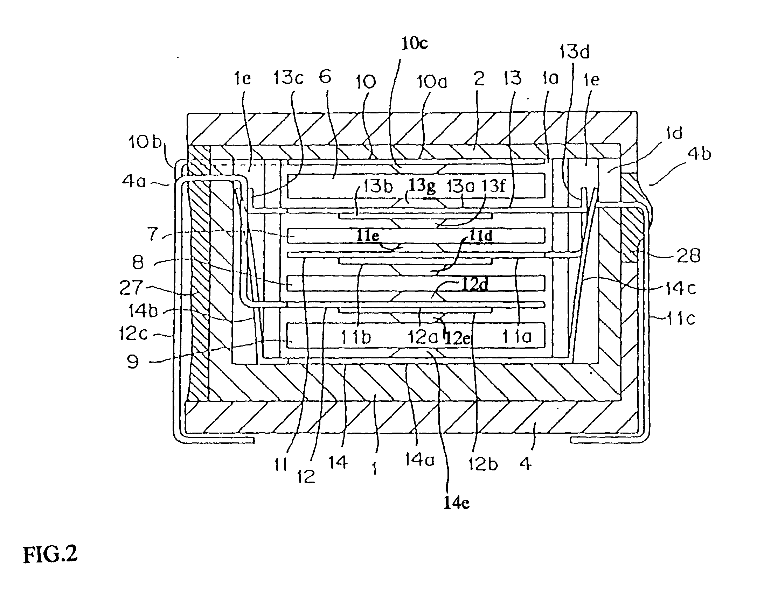

As shown in Figs.1 to 3, the ladder-type filter preferably includes an inner case 1, an outer case 4, four piezoresonators 6, 7, 8 and 9, an input terminal 10, a ground terminal 11, an output terminal 12 and a pair of relay terminals 13 and 14. The piezoresonators 6 to 9 are of the well-known type having a vibrating electrode disposed on the front and rear surfaces thereof.

The inner case 1 is preferably shaped substantially like a box and has an opening 1a at the top thereof. Grooves 1b and 1c for leading out the input terminal 10 and the output terminal 12 therethrough are formed on one of the end surfaces at the opening 1a, and a groove 1d for leading out the ground terminal 11 therethrough is formed on the other end surface. Furthermore, guide portions 1e for positioning relay strip portions 13c to 13e and 14b to 14d of the respective relay portions 13 and 14, which will be described later, are formed on two opposite inner wall surfaces of the inner case 1. As seen in Fig.1, leading ends of the guide portions 1e are formed to have a relatively wider part as compared to the remainder of the guide portions 1e.

The input terminal 10 has a contact strip portion 10a and an external connecting portion 10b, and a projection 10c formed on the contact strip portion 10a is disposed in pressing contact with the upper surface of the piezoresonator 6.

The ground terminal 11 has a contact strip portion 11a, a contact strip portion 11b doubled up, and an external connecting portion 11c. A projection 11d formed on the contact strip portion 11b is disposed in pressing contact with the upper surface of the piezoresonator 8, and a projection 11e formed on the contact strip portion 11a is in pressing contact with the lower surface of the piezoresonator 7.

The output terminal 12 has a contact strip portion 12a, a contact strip portion 12b doubled up, and an external connecting portion 12c. A projection 12d formed on the contact strip portion 12a is disposed in pressing contact with the lower surface of the piezoresonator 8, and a projection 12e formed on the contact strip portion 12b is disposed in pressing contact with the upper surface of the piezoresonator 9.

The relay terminal 13 has a contact strip portion 13a, a contact strip portion 13b doubled up, and three relay strip portions 13c, 13d and 13e. A projection 13f formed on the contact strip portion 13b is disposed in pressing contact with the upper surface of the piezoresonator 7, and a projection 13g formed on the contact strip portion 13a is in pressing contact with the lower surface of the piezoresonator 6. The three relay strip portions 13c to 13e extend upwardly from the edges of the contact strip portion 13a in an approximately vertical direction.

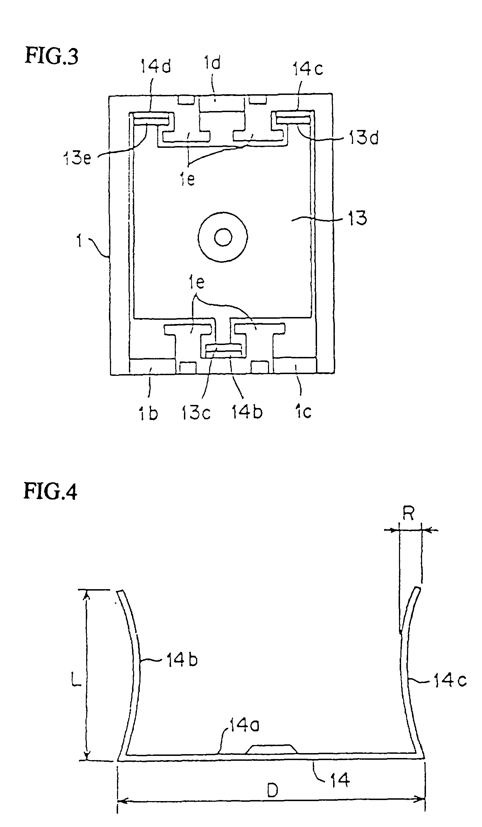

The relay terminal 14 paired with the relay terminal 13 has a contact strip portion 14a, and relay strip portions 14b, 14c and 14d, and a projection 14e formed on the contact strip portion 14a is disposed in pressing contact with the lower surface of the piezoresonator 9. The relay strip portions 14b to 14d extend upwardly from the edges of the contact strip portion 14a, and are located opposite to respective ones of the relay strip portions 13c to 13e. Furthermore, the relay strip portions 14b to 14d are longer than the relay strip portions 13c to 13e, and are curved inwardly to have a substantially convex shape as shown in Fig.4. In this preferred embodiment, when a length D of one side of the contact strip portion 14a is about 5.7mm and a length L of each of the relay strip portions 14b to 14d is about 2.8mm, a height R of the top point of the curve is set at approximately 200µm.

The piezoresonators 6 to 9 and the terminals 10 to 14 are sequentially inserted into the inner case 1 through the opening 1a, and stacked on top of one another. Since the pair of relay terminals 13 and 14 are separate from each other before assembly, they are stacked in the same manner as the terminals 10 to 12 and the piezoresonators 6 to 9. Therefore, the assembly procedure is simplified, and assembly automation is facilitated. At this time, the relay strip portions 13c to 13e and 14b to 14d of the relay terminals 13 and 14 are positioned by the guide portions 1e. Since the relay strip portions 14b to 14d are curved, the piezoresonators 6 to 9 and the terminals 10 to 12 can be easily and smoothly inserted without being inhibited or caught by the relay strip portions 14b to 14d.

The stacked relay terminals 13 and 14 are electrically connected and are physically connected so as to form a single relay terminal element by the pressing contact between the relay strip portions 13c and 14b, 13d and 14c, and 13e and 14d. In other words, the combined structure of the relay terminals 13 and 14 performs the same function as the conventional U-shaped relay terminal.

The external connecting portions 10b and 12c of the input terminal 10 and the output terminal 12 are led out from the grooves 1b and 1c, and the external connecting portion 11c of the ground terminal 11 is led out from the groove 1d.

Next, a cover 2 is put on the inner case 1. The outer case 4 is preferably a substantially rectangular housing and has openings 4a and 4b at two opposite ends thereof. The inner case 1, in which the components 6 to 14 are inserted, and the cover 2 are inserted from the opening 4a of the outer case 4.

Then, sealing materials 27 and 28 made of epoxy resin or the like are filled at the openings 4a and 4b, and cured. After this, the external connecting portions 10b, 11c and 12c are folded along the outer case 4, thereby achieving a surface mounted type component.

In the ladder-type filter obtained as described above, since the relay strip portions 14b to 14d of the relay terminal 14 are curved, even if internal pressure is applied to the relay terminal 13 from above, the force required for elastically fatiguing the relay strip portions 14b and 14d is decreased to about one tenth of the normal pressure required for fatiguing the relay strip portions 14b and 14d. Therefore, there is no possibility that pressing forces at contact portions between the relay strip portions 14b to 14d and the relay strip portions 13c to 13e will be decreased.

Furthermore, since the relay strip portions 13c to 13e and 14b to 14d are positioned by the guide portions 1e, even if a great external force is applied by the shock of the piezoelectric component falling and the like, the displacement of the relay terminals 13 and 14 is substantially minimized and controlled by the guide portions 1e functioning as stoppers. Therefore, no great force is applied to the contact portions between the relay strip portions 13c to 13e and 14b to 14d, and therefore, reliable contact between the relay terminals 13 and 14 is maintained. The guide portions 1e also serve to prevent the relay terminals 13 and 14 from being contacted and electrically connected with other components 6 to 12.

Still further, since the relay terminals 13 and 14 preferably have three relay strip portions 13c to 13e and 14b to 14d, respectively, they are contacted with each other at three positions. Therefore, if the relay terminals 13 and 14 are tilted, displaced or shocked by falling, poor contact between the relay terminals 13 and 14 is prevented.

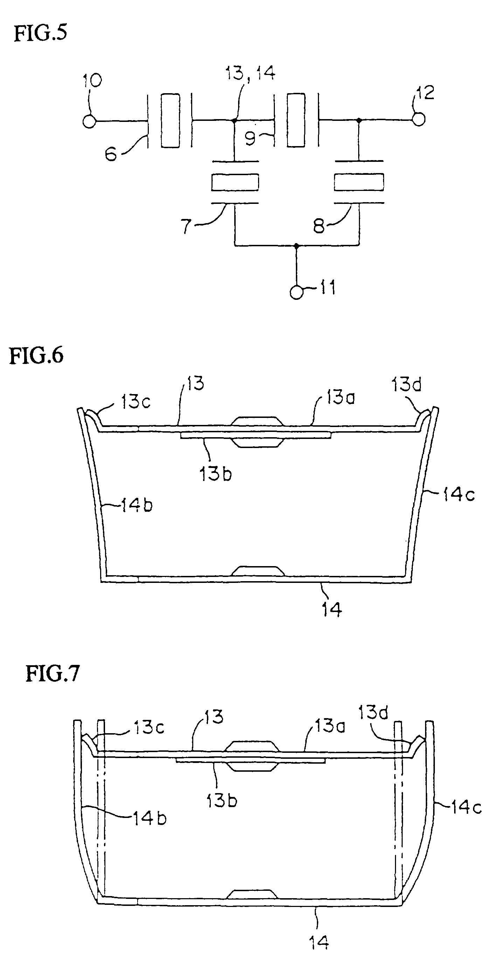

Fig.5 is an electrical equivalent circuit diagram of the ladder-type filter described above. The piezoresonators 6 and 9 are connected in series between the input terminal 10 and the output terminal 12, and the piezoresonators 7 and 8 are connected in parallel between the input terminal 10 and the output terminal 12.

The piezoelectric component of the present invention is not limited to the above-mentioned preferred embodiment, and various modifications are possible within the spirit and scope of the present invention.

Although the lower one of the pair of relay terminals has curved relay strip portions in the first preferred embodiment, the relay strip portions 13c to 13e of the upper relay terminal 13 may be also curved inwardly to have a substantially convex shape as shown in Fig.6. Furthermore, as shown in Fig.7, only the relay strip portions 13c to 13e of the relay terminal 13 may be curved inwardly to have a convex shape without curving the relay strip portions 14b to 14d of the relay terminal 14 (see an alternate long and short dash lines in the figure). In this case, when the relay terminal 13 is put into pressing contact with the relay terminal 14, the relay strip portions 14b to 14d of the relay terminal 14 extend outside of the relay terminal 13 toward the inner walls of the case.

Although the outer case is provided in the above preferred embodiment, it is not always necessary. A cover may be tightly joined to the inner case instead by a means such as an adhesive.

Furthermore, a spring member or a metal dummy member for controlling the pressing force between the piezoresonators and the terminals may be placed, for example, between the input terminal and the cover of the inner case.

Still further, the piezoelectric component of the preferred embodiments of the present invention is not limited to the ladder-type filter, and may be an oscillator, an LC filter or the like.

As described above, according to the preferred embodiments of the present invention, since a pair of relay terminals are separate before being assembled in the inner case, the relay terminals can be assembled in the same manner as other terminals and piezoresonators. The relay terminals assembled in the case are electrically connected and combined into a single structural element through the pressing contact between the relay strip portions thereof. Therefore, the pair of relay terminals are electrically connected with increased reliability, and the relay terminals perform the same function as a conventional U-shaped relay terminal. As a result, it is possible to easily achieve automatic assembly of the piezoelectric component.

Furthermore, since the relay strip portions of at least one of the pair of relay terminals are curved, there is no possibility that the relay strip portions of both the relay terminals will be elastically fatigued and that the pressing forces therebetween will be decreased.

Still further, since the relay strip portions are preferably positioned by the guide portions formed on the inner wall surface of the case, no great force is applied to the contact portions between the relay strip portions even if a great external force is applied by the shock of the piezoelectric component falling or the like, which enhances contact reliability. These guide portions also serve to prevent the relay terminals from being contacted and electrically connected with other components.

In addition, since the pair of relay terminals each preferably have three relay strip portions, they are connected with each other at three positions, and high contact reliability is maintained even when the relay terminals are tilted, displaced, or shocked by falling.

While preferred embodiments of the invention have been disclosed, various modes of carrying out the principles disclosed herein are contemplated as being within the scope of the following claims. Therefore, it is understood that the scope of the invention is not to be limited except as otherwise set forth in the claims.

## Claims

1. A piezoelectric component, comprising:
a case (1);
a piezoresonator (6-9) located in said case; and
at least first (13) and second (14) relay terminals each having a contact strip portion (13a/14a) and a relay strip portion (13c-e/14b-d) connected to said contact strip portion and being located in said case to hold said piezoresonator, said relay strip portion of at least one of said first and second relay terminals being curved;
**characterised in that** said relay strip portion of at least one of said first and second relay terminals is curved inwardly to have a substantially convex shape, so that the first and second relay terminals connect to form a single relay terminal element.

2. A piezoelectric component according to claim 1, wherein a guide portion (1e) for positioning said relay strip portions is provided on an inner wall surface of said case.

3. A piezoelectric component according to claim 1 or 2, wherein said first and second relay terminals (13/14) each have a plurality of relay strip portions.

## Patentansprüche

1. Piezoelektrisches Bauteil, das aufweist:
ein Gehäuse (1);
einen in dem Gehäuse befindlichen Piezoresonator (6-9) und
wenigstens einen ersten (13) und zweiten (14) Relaisanschluss, die jeweils einen Kontaktstreifenteil (13a-14a) und einen Relaisstreifenteil (13c-e/14b-d) haben, der mit dem Kontaktstreifenteil verbunden ist und in dem Gehäuse zum Haltern des Piezoresonators liegt, wobei der Relaisstreifenteil wenigstens eines der ersten und zweiten Relaisanschlüsse kurvenförmig ist;
**dadurch gekennzeichnet, dass** der Relaisstreifenteil wenigstens eines der beiden Relaisanschlüsse nach innen gekurvt verläuft und dadurch eine im wesentlichen konvexe Form hat, so dass der erste und zweite Relaisanschluss unter Bildung eines einzigen Relaisanschlusselements miteinander verbunden sind.

2. Piezoelektrisches Bauteil nach Anspruch 1, **dadurch gekennzeichnet, dass** ein Führungsabschnitt (1e) zur Positionierung der Relaisstreifenteile auf einer Innenwandfläche des Gehäuses vorgesehen ist.

3. Piezoelektrisches Bauteil nach Anspruch 1 oder 2, bei dem der erste und zweite Relaisanschluss (13/14) jeweils mehrere Relaisstreifenteile haben.

## Revendications

1. Composant piézoélectrique, comprenant :
un boîtier (1) ;
un piézorésonateur (6 à 9) placé dans ledit boîtier ; et
au moins une première borne de relais (13) et une deuxième borne de relais (14) ayant chacune une partie bande de contact (13a/14a) et une partie bande de relais (13c-e/14b-d) connectée à ladite partie bande de contact, et se trouvant dans ledit boîtier afin de maintenir ledit piézorésonateur, ladite partie bande de relais d'au moins l'une desdites première et deuxième bornes de relais étant incurvée ;
**caractérisé en ce que** ladite partie bande de relais d'au moins une desdites première et deuxième bornes de relais est incurvée vers l'intérieur de façon à présenter une forme sensiblement convexe, si bien que les première et deuxième bornes de relais se connectent de façon à former un unique élément home de relais.

2. Composant piézoélectrique selon la revendication 1, où une partie de guidage (1e) servant à positionner lesdites parties bande de relais est prévue sur une surface de paroi interne dudit boîtier.

3. Composant piézoélectrique selon la revendication 1 ou 2, où lesdites première et deuxième bornes de relais (13/14) possèdent chacune une pluralité de parties bande de relais.
